# EUROPÄISCHE PATENTSCHRIFT

(11) **EP 1 201 033 B1**
(45) Veröffentlichungstag und Bekanntmachung des Hinweises auf die Patenterteilung: **21.12.2005**
(21) Anmeldenummer: 00954590.6
(22) Anmeldetag: 04.08.2000
(51) Int. Cl.: H03K 19/0175

(54) **SCHALTUNGSANORDNUNG ZUR SPANNUNGSVERSORGUNG EINER INTEGRIERTEN SCHALTUNG ÜBER EIN PAD**
CIRCUIT CONFIGURATION FOR SUPPLYING POWER TO AN INTEGRATED CIRCUIT VIA A PAD
DISPOSITIF DE COMMUTATION SERVANT A L'ALIMENTATION EN TENSION D'UN CIRCUIT INTEGRE VIA UN PLOT

(30) Priorität: 04.08.1999 DE 19936606
(43) Veröffentlichungstag der Anmeldung: 02.05.2002
(73) Patentinhaber: Infineon Technologies AG, 81669 München (DE)
(72) Erfinder: KIRCHHOFF, Hans-Gerd, 40885 Ratingen (DE)
(74) Vertreter: Graf Lambsdorff, Matthias
(86) Internationale Anmeldenummer: PCT/EP2000/007605
(87) Internationale Veröffentlichungsnummer: WO 2001/011778

(56) Entgegenhaltungen:
- WO-A-99/22289
- JP-A- 9 167 828
- US-A- 5 539 338

## Beschreibung

Die Erfindung betrifft eine Schaltungsanordnung zur Spannungsversorgung einer integrierten Schaltung über ein Pad nach dem Oberbegriff von Patentanspruch 1 und ein Verfahren zur Spannungsversorgung und Konfiguration einer integrierten Schaltung über ein Pad nach dem Oberbegriff von Patentanspruch 7.

Eines der wichtigsten Ziele bei der Entwicklung integrierter Schaltungen ist die Einsparung wertvoller Chipfläche. Je kleiner eine integrierte Schaltung ist, desto höher ist auch die effektive Ausbeute pro Wafer bei der Herstellung. Einen weiteren Kostenfaktor bildet das Chipgehäuse, in das die integrierte Schaltung eingebaut wird. Dabei wird der Gehäusetyp hauptsächlich durch die Anzahl der Pads bzw. Anschlüsse der integrierten Schaltung bestimmt. Um ein billiges Chipgehäuse verwenden zu können, wird daher eine Einsparung von Pads bei der Entwicklung integrierter Schaltungen angestrebt.

Bei komplexen integrierten Schaltungen wie Mikroprozessoren oder aufwendigen Mikrokontrollern sind viele der vorhandenen Pads ausschließlich zur Spannungsversorgung vorgesehen. Wird auf einige der zur Spannungsversorgung vorgesehenen Pads zugunsten eines billigeren Chipgehäuses verzichtet, steigt allerdings das Risiko von Funktionsstörungen aufgrund einer möglicherweise zu geringen Stromversorgung über die verbleibenden Pads für die Spannungsversorgung und zudem wird der Chip störungsempfindlicher gegenüber externen Störungen aufgrund von EMV (Elektromagnetischer Verträglichkeit). Ferner strahlt der Chip selber stärker und kann damit in einem elektronischen System andere Chips oder Bauelemente stören. Auch auf funktionale Pads oder für das Testen vorgesehene Pads kann ebenfalls nur selten verzichtet werden

Aufgabe der vorliegenden Erfindung ist es daher, eine Schaltung und ein Verfahren anzugeben, wobei eine Einsparung von Pads zur Spannungsversorgung bei integrierten Schaltungen, ohne dabei die eingangs erwähnten Nachteile in Kauf zu nehmen, ermöglicht wird.

In der Druckschrift US 5 936 423 A ist eine Schaltungsanordnung offenbart, bei der ein in einem Versorgungsspannungszweig angeordnetes Pad, über welches eine integrierte Schaltung auf ein Bezugspotential gelegt wird oder mit einer Versorgungsspannung versorgt wird, als Test-Pad während eines Testbetriebs der integrierten Schaltung verwendet wird. Zu diesem Zweck weist die Schaltung gemäß der Fig. 6 der Druckschrift ein zweites für die Funktionsweise der Schaltung notwendiges Testbetriebs-Pad auf. Des Weiteren weist die Schaltung eine Steuerschaltung bestehend aus zwei OR-Gattern sowie einem Inverter auf. Das Testbetriebs-Pad ist dabei mit dem ersten OR-Gatter und mit einem negierten Eingang des zweiten OR-Gatters und daher lediglich mit der Steuerschaltung und mit der integrierten Schaltung elektrisch verbunden. Das zweite Pad ist mit der integrierten Schaltung und mit einer ersten Schalter verbunden, weist aber keine elektrische Verbindung zur Signalleitung des Testbetriebs-Pads auf.

Diese Aufgabe wird durch eine Schaltungsanordnung zur Spannungsversorgung einer integrierten Schaltung über ein Pad mit den Merkmalen von Patentanspruch 1 und ein Verfahren zur Spannungsversorgung und Konfiguration einer integrierten Schaltung über ein Pad mit den Merkmalen von Patentanspruch 7 gelöst. Bevorzugte Ausgestaltungen der Erfindung sind Gegenstand der abhängigen Patentansprüche.

Die Erfindung betrifft eine Schaltungsanordnung zur Spannungsversorgung einer integrierten Schaltung über ein Pad gemäß Patentanspruch 1.

Bei vielen integrierten Schaltungen, insbesondere bei sehr komplexen, sind einige Pads zur Konfiguration der integrierten Schaltung vorgesehen. Beispielsweise kann über diese Pads ein bestimmter Betriebsmodus eingestellt werden oder die integrierte Schaltung kann in einen Testmodus zum Testen bestimmter Module geschaltet werden. In einem elektronischen System sind diese Pads während dem Betrieb der integrierten Schaltung ständig mit einer Versorgungsspannung de integrierten Schaltung verbunden. Demnach können diese Pads, die eigentlich zur Konfiguration der integrierten Schaltung vorgesehen sind, auch zur Spannungsversorgung benutzt werden. Die eigentliche Funktion des Pads wird dadurch nicht beeinträchtigt, sondern bleibt erhalten. Allerdings kann die integrierte Schaltung über das Pad nur mit der Spannung, die zur Konfiguration anliegt, versorgt werden. Dazu sind erfindungsgemäß auf der integrierten Schaltung Schalter vorgesehen, die ein Pad jeweils mit einer der Versorgungsspannungen der integrierten Schaltung verbinden. Vorteilhafterweise können dadurch Pads für die Spannungsversorgung eingespart werden.

Die Steuerschaltung schaltet die Schalter über jeweils eine Treiberschaltung ein oder aus, wobei die Eingänge der Treiberschaltungen direkt mit dem Pad verbunden sind. Die Steuerschaltung sperrt oder entsperrt dazu die Treiberschaltungen, die eine am Pad anliegende Spannung zum Schalten der Schalter verwenden.

Die Ausgänge der Treiberschaltungen sind vorzugsweise jeweils über einen Widerstand mit einer der Versorgungsspannungen auf der integrierten Schaltung verbunden. Dies bewirkt eine Pull-Funktion, so daß die Treiberausgänge, auch wenn die Treiberschaltungen abgeschaltet sind, auf einem definierten Potential liegen und die Schalter definiert ein- oder ausgeschaltet sind.

Insbesondere sind die Schalter als Leistungstransistoren ausgeführt. Um die integrierte Schaltung über das Pad mit ausreichend Strom zu versorgen, sind Leistungstransistoren besonders für einen hohen Stromfluß über das Pad geeignet. Einfache Transistoren würden dagegen nur den möglichen Versorgungsstrom über das Pad begrenzen.

Die integrierte Schaltung weist vorzugsweise in einer Ausführungsform der Erfindung eine erste Versorgungsspannung und eine zweite Versorgungsspannung und einen ersten Schalter und einen zweiten Schalter auf. Dabei verbindet der erste Schalter das Pad mit der ersten Versorgungsspannung und der zweite Schalter das Pad mit der zweiten Versorgungsspannung. Viele integrierte Schaltungen werden heutzutage mit zwei Versorgungsspannung, beispielsweise 5 V und 0 V, versorgt. In diesem Fall sind genau zwei Schalter zur Ausführung der Erfindung nötig, die das Pad mit beispielsweise 5 V und mit 0 V verbinden.

Das Pad ist vorzugsweise über die Laststrecke eines dritten Transistors und die Laststrecke eines vierten Transistors mit der ersten Versorgungsspannung bzw. der zweiten Versorgungsspannung verbunden, wobei der Steueranschluß des dritten Transistors mit der zweiten Versorgungsspannung und der Steueranschluß des vierten Transistors mit der ersten Versorgungsspannung verbunden ist. Bei dieser Ausführungsform der Erfindung wird ein "Floaten" des Pads vermieden und das Pad liegt solange keine externe Spannung anliegt auf einem definierten Potential.

Insbesondere sind der erste und zweite Transistor als MOS-Transistoren ausgeführt. Diese Ausführung ist dann vorteilhaft, wenn die integrierte Schaltung in einer reinen MOS-Technologie gefertigt wird. Alternativ können der erste und zweite Transistor als Bipolartransistoren ausgeführt sein. Wird die integrierte Schaltung in einer BiCMOS-Technologie gefertigt, bietet sich diese Ausführung an, da sich Bipolartransistoren insbesondere als Stromquellen eignen und sehr große Ströme verkraften.

Die Erfindung betrifft ferner ein Verfahren zur Spannungsversorgung und Konfiguration einer integrierten Schaltung über ein Pad, wobei an dem Pad eine Spannung anliegt. Erfindungsgemäß ist bei dem Verfahren eine Schaltungsanordnung zur Spannungsversorgung einer integrierten Schaltung über ein Pad auf der integrierten Schaltung nach Anspruch 1 vorgesehen, wobei die Spannung sowohl zur Konfiguration der integrierten Schaltung als auch zur Spannungsversorgung der integrierten Schaltung dient.

Aus der nachfolgenden Beschreibung von Ausführungsbeispielen in Verbindung mit der Zeichnung ergeben sich weitere Vorteile und Anwendungsmöglichkeiten der Erfindung. Die Zeichnung zeigt dabei in
Figur 1 eine prinzipielle Ausführung der Schaltungsanordnung zur Spannungsversorgung einer integrierten Schaltung über ein Pad, und
Figur 2 eine praktische Realisation der Schaltungsanordnung zur Spannungsversorgung einer integrierten Schaltung über ein Pad in MOS-Technologie.

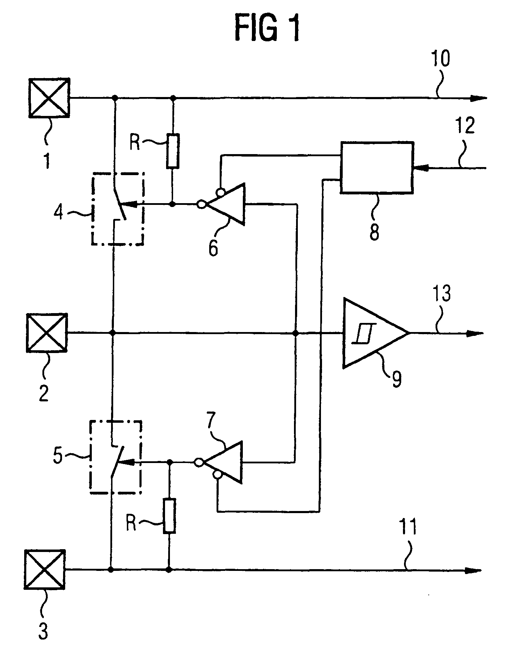

Figur 1 zeigt einen Ausschnitt aus einer integrierten Schaltung. Dargestellt ist ein erstes Pad 1 zur Spannungsversorgung der integrierten Schaltung mit einer ersten Versorgungsspannungsleitung 10, die beispielsweise 5 V führt, ein zweites Pad 2 zur Konfiguration der integrierten Schaltung und ein drittes Pad 3 zur Verbindung der integrierten Schaltung mit einem Bezugspotentialleitung 11, die ein Potential von beispielsweise 0 V aufweist.

Das zweite Pad ist mit einem Schmitt-Trigger 9 verbunden, dessen Ausgangssignal 13 zur Konfiguration der integrierten Schaltung dient. Der Schmitt-Trigger 9 erzeugt dabei aus einer am zweiten Pad 2 anliegenden Spannung einen logischen Pegel, der zur Weiterverarbeitung auf der integrierten Schaltung geeignet ist. Zudem filtert der Schmitt-Trigger 9 Störspannungen am Pad 2 weg.

Über einen ersten Schalter 4 ist das zweite Pad 2 mit der ersten Versorgungsspannungsleitung 10 verbunden. Ein zweiter Schalter 5 verbindet das zweite Pad 2 ferner mit der Bezugspotentialleitung 11.

Der erste Schalter 4 wird von einem ersten Tristate-Inverter 6 angesteuert. Der zweite Schalter 5 wird von einem zweiten Tristate-Inverter 7 angesteuert. Der erste Tristate-Inverter 6 und der zweite Tristate-Inverter 7 wird von einer Steuerschaltung 8 an- oder abgeschaltet. Die Steuerschaltung 8 wird von einem chipinternen Signal 12, beispielsweise einem RESETSignal, angesteuert. Der Eingang des ersten Tristate-Inverters 6 und des zweiten Tristate-Inverters 7 ist mit dem zweiten Pad 2 verbunden. Der Ausgang des ersten Tristate-Inverters 6 und des zweiten Tristate-Inverters 7 ist jeweils über einen Widerstand R mit der Versorgungsspannungsleitung 10 bzw. der Bezugspotentialleitung 11 verbunden.

Im Betrieb der Schaltungsanordnung liegt an dem zweiten Pad 2 eine externe Spannung von beispielsweise 5 V zur Konfiguration an. In diesem Fall kann die externe Spannung neben der Konfiguration zur Spannungsversorgung der integrierten Schaltung mit 5 V benutzt werden. Die Steuerschaltung 8 schaltet die beiden Tristate-Inverter 6 und 7 an. An den Eingängen der beiden Tristate-Inverter 6 und 7 liegt die externe Spannung an. Beide Tristate-Inverter 6 und 7 invertieren die Spannung und führen die invertierte Spannung dem ersten Schalter 4 bzw. dem zweiten Schalter 5 zu. Der Eingang der ersten Schalters 4 ist gegenüber dem Eingang des zweiten Schalters 5 invertiert, so daß nur der erste Schalter 4 eingeschaltet wird und der zweite Schalter 5 offen bleibt. Somit ist das zweite Pad 2 mit der Versorgungsspannungsleitung 10 verbunden und die externe Spannung versorgt über das zweite Pad 2 und den ersten Schalter 4 die integrierte Schaltung mit 5 V. Soll die integrierte Schaltung über das zweite Pad 2 nicht versorgt werden, schaltet die Steuerschaltung 8 die beiden Tristate-Inverter 6 und 7 ab. In diesem Fall bewirken die Widerstände R, daß an dem Eingang des ersten Schalters 4 und des zweiten Schalters 5 die erste Versorgungsspannung bzw. das Bezugspotential liegt. Beide Schalter sind dann offen und die Verbindung zwischen dem zweiten Pad 2 und der Versorgungsspannungsleitung sowie der Bezugspotentialleitung ist getrennt.

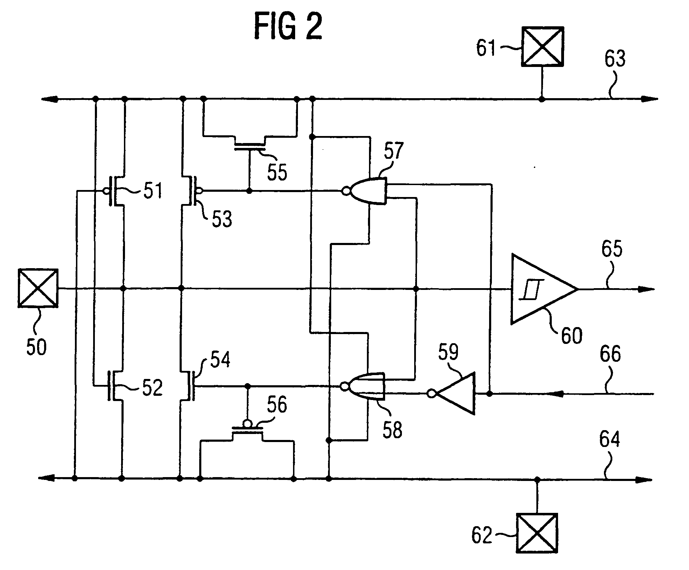

In Figur 2 ist ebenfalls ein Ausschnitt aus einer integrierten Schaltung dargestellt. Ein erstes Pad 61 dient zur Spannungsversorgung der integrierten Schaltung mit einer ersten Versorgungsspannungsleitung 63, die beispielsweise 5 V führt. Über ein drittes Pad 62 wird die integrierte Schaltung mit einem Bezugspotential verbunden. Das dritte Pad ist dazu auf der integrierten Schaltung mit einer Bezugspotentialleitung 64 verbunden. Ein zweites Pad 50 dient zur Konfiguration der integrierten Schaltung.

Das zweite Pad ist mit einem Schmitt-Trigger 60 verbunden, dessen Ausgangssignal 65 an ein internes Modul der integrierten Schaltung geführt wird und dort einen bestimmten Betriebsmodus der integrierten Schaltung einstellt. Der Schmitt-Trigger 60 erzeugt dabei aus einer am zweiten Pad 50 anliegenden Spannung einen logischen Pegel, der einem der auf der integrierten Schaltung verwendeten logischen Pegeln entspricht. Zudem filtert der Schmitt-Trigger 60 Störspannungen am zweiten Pad 50 weg. Als Schmitt-Trigger eignet sich besonders die aus der deutschen Patentschrift DE 44 27 015 C1 bekannte Schaltung.

Über die Laststrecke eines ersten p-Kanal-MOS-Transistors 53 ist das zweite Pad 50 mit der ersten Versorgungsspannungsleitung 63 verbunden. Die Laststrecke eines ersten n-Kanal-MOS-Transistors 54 verbindet das zweite Pad 50 ferner mit der Bezugspotentialleitung 64. Der erste p-Kanal-MOS-Transistor 53 und der erste n-Kanal-MOS-Transistor 54 sind als Leistungstransistoren ausgelegt, um die integrierte Schaltung über das zweite Pad 50 mit Strom zu versorgen.

Der erste p-Kanal-MOS-Transistor 53 wird von einem Nand-Gatter 57 angesteuert. Der erste n-Kanal-MOS-Transistor 54 wird von einem Nor-Gatter 58 angesteuert. Ein erster Eingang des Nand-Gatters 57 wird von einem "Enable"-Signal 66 der integrierten Schaltung angesteuert. Das "Enable"-Signal 66 steuert zudem über einen Inverter 59 einen ersten Eingang des Nor-Gatters 58 an. Ein zweiter Eingang des Nand-Gatters 57 und des Nor-Gatters 58 sind mit dem zweiten Pad 50 verbunden. Ist das "Enable"-Signal 66 logisch Null, so ist die Spannungsversorgung über das zweite Pad 50 abgeschaltet.

Die Laststrecke eines zweiten p-Kanal-MOS-Transistors 51 oder eines zweiten n-Kanal-MOS-Transistors 52 verbindet ebenfalls das zweite Pad 50 mit der entsprechenden Versorgungsspannungsleitung. Ist der zweite p-Kanal-MOS-Transistors 51 in der Schaltung angeordnet, so ist das Gate des zweiten p-Kanal-MOS-Transistors 51 mit der Bezugspotentialleitung 64 verbunden, so daß der zweite p-Kanal-MOS-Transistor 51 immer eingeschaltet ist und das zweite Pad 50 auf ein definiertes Potential legt. Ist der zweite n-Kanal-MOS-Transistors 52 in der Schaltung vorhanden, so ist das Gate des zweiten n-Kanal-MOS-Transistors 52 mit der Bezugspotentialleitung 63 verbunden, so daß der zweite p-Kanal-MOS-Transistor 52 immer eingeschaltet ist und das zweite Pad 50 auf ein definiertes Potential legt. Mit anderen Worten, der p-Kanal-MOS-Transistor 51 und der n-Kanal-MOS-Transistor 52 sind niemals gleichzeitig in der Schaltung integriert, sondern sollen nur den Grundzustand einstellen. Ist daher ein positiver Defaultwert für den Schmitt-Trigger 60 notwendig, so wird der p-Kanal-MOS-Transistor 51 verwendet, anderenfalls wird für einen negativen Defaultwert des Schmitt-Triggers 60 der-Kanal-MOS-Transistor 52 verwendet. Zur Abdeckung der beiden Varianten sind beide Transistoren 51, 52 in der Fig. 2 eingefügt, obwohl sie nicht gleichzeitig in einer entsprechenden Schaltung vorhanden sind.

Das Gate eines dritten n-Kanal-MOS-Transistors 55 und das Gate eines dritten p-Kanal-MOS-Transistors 56 ist mit dem Ausgang des Nand-Gatters 57 bzw. des Nor-Gatters 58 verbunden und bildet jeweils ein Kapazität, die einerseits das Einschalten des ersten p-Kanal-MOS-Transistors 53 bzw. des ersten n-Kanal-MOS-Transistors 56 verzögert und andererseits als Millerkapazitäten interne Störungen/Spannungsspitzen der Versorgungsleitungen 63 oder 64 auf die Gates der Leistungstransistoren 53 bzw. 54 mitkoppeln, wobei die Wirkung als Millerkapazität der hauptsächlich gewünschte Effekt ist. Dadurch werden die Leistungstransistoren noch stärker aufgesteuert, was deren RDSₒₙ noch weiter reduziert, so daß die Störungen/Spannungsspitzen zusätzlich gedämpft werden. Die Laststrecke des dritten p-Kanal-MOS-Transistors 56 und des dritten n-Kanal-MOS-Transistors 55 sind parallel zu der Bezugspotentialleitung 64 bzw. der Versorgungsspannungsleitung 63 geschaltet und wirken als Miller-Kapazität.

Wird die integrierte Schaltung über das erste Pad 61 und das dritte Pad 62 an die Versorgungsspannung bzw. das Bezugspotential geschaltet, ist das "Enable"-Signal 66 zuerst logisch Null und der erste p-Kanal-MOS-Transistor 53 und der erste n-Kanal-MOS-Transistor 54 ist abgeschaltet. Das zweite Pad 50 dient somit nur zum Konfigurieren der integrierten Schaltung. Sobald die integrierte Schaltung anfängt zu arbeiten, kann das "Enable"-Signal 66 au logisch Eins gehen. Je nachdem, welcher logische Pegel entsprechend der externen Spannung am zweiten Pad 50 anliegt, geht entweder der Ausgang des Nand-Gatters 57 auf logisch Null (logischer Pegel am zweiten Pad 50: Eins!) und der Ausgang des Nor-Gatters 58 auf logisch Null oder der Ausgang des Nand-Gatters 57 auf logisch Eins (logischer Pegel am zweiten Pad 50: Null!) und der Ausgang des Nor-Gatters 58 auf logisch Eins. Der erste p-Kanal-MOS-Transistor 53 wird eingeschaltet und der erste n-Kanal-MOS-Transistor 54 abgeschaltet bzw. der erste p-Kanal-MOS-Transistor 53 wird abgeschaltet und der erste n-Kanal-MOS-Transistor 54 eingeschaltet. Parallel wird die externe Spannung am zweiten Pad 50 über den Schmitt-Trigger 60 an die integrierte Schaltung zur Auswertung weitergegeben.

Die offenbarte Schaltungsanordnung läßt sich nicht nur zur Spannungsversorgung verwenden, sondern eignet sich auch für Pads, die den Abschluß beispielsweise einer 50 Q-Koaxialleitung bilden. Hierbei kann die aufgrund des Abschlusses verbrauchte Energie für die Spannungsversorgung ausgenutzt werden. Dazu muß die Schaltungsanordnung so erweitert werden, daß die abzuschließende Leitung immer einen realen und konstanten Abschlußwiderstand sieht. Die an diesem Widerstand abfallende Spannung kann dann für die chipinterne Spannungsversorgung genutzt werden.

## Patentansprüche

1. Schaltungsanordnung zur Spannungsversorgung einer integrierten Schaltung über ein Pad, wobei das Pad (2; 50) zur Konfiguration der integrierten Schaltung vorgesehen ist, wobei die integrierte Schaltung eine Vielzahl von Versorgungsspannungen (10, 11; 63, 64) zur Spannungsversorgung aufweist,
**dadurch gekennzeichnet, daß**
- das Pad (2; 50) über einen ersten Schalter (4; 53) mit einer ersten Versorgungsspannungsleitung (10; 63) und über einen zweiten Schalter (5; 54) mit einer zweiten Versorgungsspannungsleitung (11; 64) verbunden ist,
- das Pad (2; 50) mit dem Eingang einer ersten Treiberschaltung (6; 57) verbunden ist, welche mit dem ersten Schalter (4; 53) verbunden ist, und das Pad (2; 50) mit dem Eingang einer zweiten Treiberschaltung (7; 58) verbunden ist, welche mit dem zweiten Schalter (5; 54) verbunden ist,
- eine Steuerschaltung (8; 57-59) vorgesehen ist, welche von einem chipinternen Steuersignal (12; 66) angesteuert wird und die Schalter (4, 5; 53, 54) ein- oder ausschaltet.

2. Schaltungsanordnung nach Anspruch 1,
**dadurch gekennzeichnet, daß**
die Ausgänge der Treiberschaltungen (6, 7; 57, 58) jeweils über einen Widerstand (R) mit einer der Versorgungsspannungen (10, 11; 63, 64) verbunden sind.

3. Schaltungsanordnung nach einem der Ansprüche 1 oder 2,
**dadurch gekennzeichnet, daß**
die Schalter (4, 5; 53, 54) als Leistungstransistoren ausgeführt sind.

4. Schaltungsanordnung nach einem der vorhergehenden Ansprüche, **dadurch gekennzeichnet, daß**
das Pad (50) über die Laststrecke eines dritten Transistors (51) und die Laststrecke eines vierten Transistors (52) mit der ersten Versorgungsspannung (63) bzw. der zweiten Versorgungsspannung (64) verbunden ist, wobei der Steueranschluß des dritten Transistors (51) mit der ersten Versorgungsspannung (63) und der Steueranschluß des vierten Transistors (52) mit der zweiten Versorgungsspannung (64) verbunden ist.

5. Schaltungsanordnung nach einem der Ansprüche 3 oder 4,
**dadurch gekennzeichnet,daß**
der erste und zweite Transistor (53 - 54) als MOS-Transistoren ausgeführt sind.

6. Schaltungsanordnung nach einem der Ansprüche 3 oder 4,
**dadurch gekennzeichnet, daß**
der erste und zweite Transistor (53 - 54) als Bipolartransistoren ausgeführt sind.

7. Verfahren zur Spannungsversorgung und Konfiguration einer integrierten Schaltung über ein Pad (2; 50), wobei an dem Pad (2; 50) eine Spannung anliegt;
**dadurch gekennzeichnet, daß**
eine Schaltungsanordnung zur Spannungsversorgung einer integrierten Schaltung über ein Pad auf der integrierten Schaltung nach Anspruch 1 vorgesehen ist und die Spannung sowohl zur Konfiguration der integrierten Schaltung als auch zur Spannungsversorgung der integrierten Schaltung dient.

## Claims

1. Circuit arrangement for supplying voltage to an integrated circuit via a pad, the pad (2; 50) being provided for configuring the integrated circuit, the integrated circuit having a multiplicity of supply voltages (10, 11; 63, 64) for voltage supply purposes,
**characterized**
**in that** the pad (2; 50) is connected to a first supply voltage line (10; 63) via a first switch (4; 53) and to a second supply voltage line (11; 64) via a second switch (5; 54);
the pad (2; 50) is connected to the input of a first driver circuit (6; 57), which is connected to the first switch (4; 53), and the pad (2; 50) is connected to the input of a second driver circuit (7; 58), which is connected to the second switch (5; 54),
- a control circuit (8; 57 - 59) is provided, which is actuated by an on-chip control signal (12; 66) and switches the switches (4, 5; 53, 54) on or off.

2. Circuit arrangement according to Claim 1, **characterized in that** the outputs of the driver circuits (6, 7; 57, 58) are connected to one of the supply voltages (10, 11; 63, 64) via a respective resistor (R).

3. Circuit arrangement according to either of Claims 1 and 2, **characterized in that** the switches (4, 5; 53, 54) are embodied as power transistors.

4. Circuit arrangement according to one of the preceding claims, **characterized in that** the pad (50) is connected to the first supply voltage (63) and to the second supply voltage (64) via the load path of a third transistor (51) and the load path of a fourth transistor (52), respectively, the control terminal of the third transistor (51) being connected to the first supply voltage (63) and the control terminal of the fourth transistor (52) being connected to the second supply voltage (64).

5. Circuit arrangement according to either of Claims 3 and 4, **characterized in that** the first and second transistors (53 - 54) are embodied as MOS transistors.

6. Circuit arrangement according to either of Claims 3 and 4, **characterized in that** the first and second transistors (53 - 54) are embodied as bipolar transistors.

7. Method for supplying voltage to and configuring an integrated circuit via a pad (2; 50), a voltage being present at the pad (2; 50),
**characterized**
**in that** provision is made of a circuit arrangement for supplying voltage to an integrated circuit via a pad on the integrated circuit according to Claim 1 and the voltage serves both for configuring the integrated circuit and for supplying the voltage to the integrated circuit.

## Revendications

1. Montage pour l'alimentation en tension d'un circuit intégré par l'intermédiaire d'une plage de connexion, la plage de connexion (2 ; 50) étant prévue pour la configuration du circuit intégré, le circuit intégré comportant plusieurs tensions d'alimentation (10, 11 ; 63, 64) pour l'alimentation en tension,
**caractérisé par le fait que**
- la plage de connexion (2 ; 50) est reliée par l'intermédiaire d'un premier interrupteur (4 ; 53) à une première ligne de tension d'alimentation (10 ; 63) et par l'intermédiaire d'un deuxième interrupteur (5 ; 54) à une deuxième ligne de tension d'alimentation (11 ; 64),
- la plage de connexion (2 ; 50) est reliée à l'entrée d'un premier circuit d'attaque (6 ; 57) qui est relié au premier interrupteur (4 ; 53) et la plage de connexion (2 ; 50) est reliée à l'entrée d'un deuxième circuit d'attaque (7 ; 58) qui est relié au deuxième interrupteur (5 ; 54),
- il est prévu un circuit de commande (8 ; 57 à 59) qui est commandé par un signal de commande (12 ; 66) interne à la puce et qui ouvre ou ferme les interrupteurs (4, 5 ; 53, 54).

2. Montage selon la revendication 1,
**caractérisé par le fait que** les sorties des circuits d'attaque (6, 7 ; 57, 58) sont reliées respectivement par l'intermédiaire d'une résistance (R) à l'une des tensions d'alimentation (10, 11 ; 63, 64).

3. Montage selon l'une des revendications 1 ou 2,
**caractérisé par le fait que** les interrupteurs (4, 5 ; 53, 54) sont réalisés comme des transistors de puissance.

4. Montage selon l'une des revendications précédentes,
**caractérisé par le fait que** la plage de connexion (50) est reliée respectivement par l'intermédiaire de la section de charge d'un troisième transistor (51) et de la section de charge d'un quatrième transistor (52) à la première tension d'alimentation (63) et à la deuxième tension d'alimentation (64), la borne de commande du troisième transistor (51) étant reliée à la première tension d'alimentation (63) et la borne de commande du quatrième transistor (52) étant reliée à la deuxième tension d'alimentation (64).

5. Montage selon l'une des revendications 3 ou 4,
**caractérisé par le fait que** le premier et le deuxième transistor (53 et 54) sont réalisés comme des transistors MOS.

6. Montage selon l'une des revendications 3 ou 4,
**caractérisé par le fait que** le premier et le deuxième transistor (53 et 54) sont réalisés comme des transistors bipolaires.

7. Procédé pour l'alimentation en tension et la configuration d'un circuit intégré par l'intermédiaire d'une plage de connexion (2 ; 50), une tension étant appliquée à la plage de connexion (2 ; 50),
**caractérisé par le fait qu'**il est prévu un montage pour l'alimentation en tension d'un circuit intégré par l'intermédiaire d'une plage de connexion sur le circuit intégré selon la revendication 1 et que la tension sert aussi bien à la configuration du circuit intégré qu'à l'alimentation en tension du circuit intégré.
